# EUROPEAN PATENT APPLICATION

(11) **EP 1 119 054 A1**
(43) Date of publication of application: **25.07.2001**
(21) Application number: 99944857.4
(22) Date of filing: 28.09.1999
(51) Int. Cl.: H01L 29/80

(54) **ELECTROSTATIC INDUCTION TRANSISTOR**

(30) Priority: 30.09.1998 JP 27695498
(71) Applicant: Hitachi, Ltd., Chiyoda-ku, Tokyo 101-8010 (JP)
(72) Inventor: YATSUO, Tsutomu Hitachi Res. Lab. of Hitachi, Ltd., Hitachi-shi Ibaraki 319-1292 (JP); OHNO, Toshiyuki Hitachi Res. Lab. of Hitachi, Ltd., Hitachi-shi Ibaraki 319-1292 (JP); ONOSE, Hidekatsu Hitachi Res. Lab. Hitachi, Ltd., Hitachi-shi Ibaraki 319-1292 (JP); OIKAWA, Saburo Hitachi Res. Lab. Hitachi, Ltd., Hitachi-shi Ibaraki 319-1292 (JP)
(74) Representative: Beetz & Partner Patentanwälte
(86) International application number: JP9905278
(87) International publication number: WO0019541

(57) **Abstract**

In a static induction transistor, in addition to a first gate layer (4), a plurality of second gate layers (41) having a shallower depth and a narrower gap therebetween than those of the first gate layer (4) are provided in an area surrounded by the first gate layer (4), thereby an SiC static induction transistor with an excellent off characteristic is realized, while ensuring a required processing accuracy during production thereof.

## Description

### BACKGROUND OF THE INVENTION

### FIELD OF THE INVENTION

The present invention relates to an improvement in the structure of a static induction transistor.

### CONVENTIONAL ART

In association with a demand of an increasing electric power and of a high frequency operation of a power inverter, semiconductor switching elements with a low loss and a high speed operation as well as with a large controllable current are demanded.

To meet with these demands, a switching element using silicon carbide (SiC) as its base material is proposed. For example, a power MOSFET as disclosed in "High-Voltage Double-Implanted Power MOSFET's in 6H-SiC" (IEEE Electron Devices Letters, Vol.18, NO.3, p.93-95(1997)) is investigated. However, in the power MOSFET an inversion layer having a low carrier mobility is used for a channel layer serving as a current passage, there arises a problem of increasing its on voltage.

Another static induction transistor is promising which does not use such inversion layer as a channel layer in order to avoid such problem as disclosed, for example, in "Field-effect Transistor Versus Analog Transistor (Static Induction Transistor)" (IEEE Trans. on Electron Devices, Vol. ED-22, p.185-197, 1975).

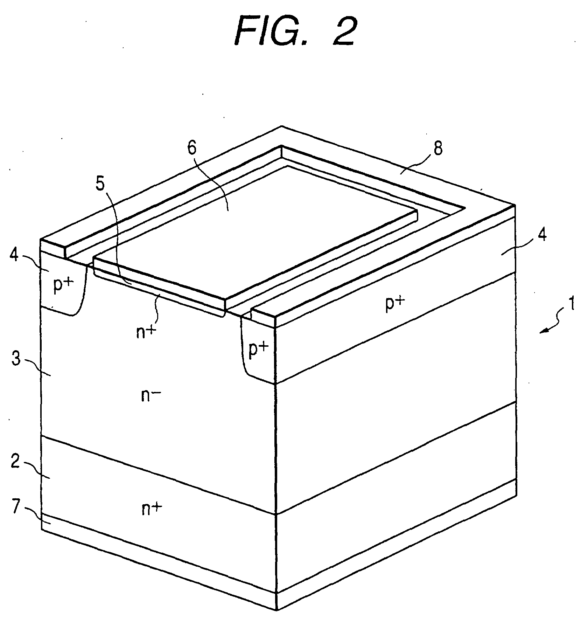

Fig. 2 shows a perspective cross sectional view of a conventional static induction transistor. A semiconductor substrate 1 of the static induction transistor is constituted by an n⁺ conductive type region 2, an n⁻ conductive type region 3, a p⁺ conductive type region 4 and n⁺ conductive type source layer 5, and is provided with a source electrode 6, a drain electrode 7 and a gate electrode 8. Through reducing the potential of the gate electrode 8 with respect to the source electrode 6 a depletion layer is spread between the p⁺ conductive type layers 4, namely in a region so called channel, thereby a current flowing between the drain electrode 7 and the source electrode 6 can be turned off. For example, " Electrical Characteristics of A Novel Gate Structure 4H-SiC Power Static Induction Transistor" ( International Conference on Silicon Carbide, III-nitrides and Related Materials-1997, Abstract p.443( 1997)) reports a possibility that an extremely low on resistance is realized because of the use of an SiC base material for the channel region.

However, with the base structure as shown in Fig. 2, there arises a problem that its off characteristic is extremely undesirable because of a production process limitation inherent to SiC which will be explained below. Namely, in the above conventional static induction transistor, it is necessary to narrow the gap between the p⁺ conductive type layers 4 in such an extent that the respective depletion layers thereof overlap each other, when a gate voltage is applied thereto during off period thereof, as well as the p⁺ conductive type layers 4 have to be formed as deep as possible and in a high density layers so as to hold an off ability with a comparatively low gate voltage for a high reverse voltage of hundreds to thousands volt. However, the junction of SiC is designed to make use of its inherent material characteristic that the dielectric breakdown electric field of its junction is about ten times larger than that of Si, the impurity density of the n- conductive type layer 3 is usually set in a high density of 70~100 times in comparison with the use of Si, therefore, the expansion of the depletion layers is extremely limited, for this reason it is necessary that the gap between the p⁺ conductive type layers 4 has to set at an extremely narrow amount such as about 1*µ*m or less than 1*µ*m in order to obtain a pinch off effect due to the depletion layer. Further, a deep p conductive type layer is formed for Si through a thermal diffusion of acceptor impurities such as boron and aluminum, however, since the diffusion coefficients of these impurities are extremely low for SiC, the thermal diffusion method can not be used for SiC and the deep p conductive type layer has to be directly formed only by an ion implantation method. However, it is quite difficult to selectively form a deep implantation layer of about 1*µ* m with narrow gaps only through an ion implantation. Because, it is quite difficult to produce an implantation mask with a large film thickness and a narrow gap. For example, when using a photo resist which is commonly and usually used as an implantation mask, an implantation energy of about 500keV is required for implanting boron in a depth of 1*µ*m, and the mask thickness of more than 4*µ* m is necessary for enduring the implantation energy. It is very hard to process the width and gap in such a thick photo resist in a range of less than 1*µ*m with a high accuracy. Accordingly, with the static induction transistor (hereinafter, abbreviated as SIT) using SiC and with the base structure as shown in Fig. 2 a characteristic with a large gate off gain can not be expected, moreover a realization of an SIT with a normally off function is almost impossible.

As has been explained above, when applying the conventional measures used in connection with Si as it is to a static induction transistor using SiC as its base material, a necessary channel width is about 1*µ*m for obtaining a comparatively high off gain, therefore, the formation of a deep p conductive type gate layer with a high impurity density through an ion implantation method is quite difficult due to the limitation of the implantation mask processing accuracy. Further, since the source layer has to be formed in such a narrow gap, an extremely high accuracy is required for their pattern matching. As a result, a production of an SIT having an excellent off characteristic including normally off function is difficult.

### SUMMARY OF THE INVENTION

An object of the present invention is to provide a static induction transistor with a new structure which resolves the above mentioned problems.

Another object of the present invention is to provide a static induction transistor with a new structure which shows an excellent off characteristic.

Still another object of the present invention is to provide a static induction transistor with a new structure which permits a production thereof with a high yield.

In order to achieve the above objects, a gate region of the static induction transistor according to the present invention is structured in such a manner to provide a first gate layer and a plurality of second gate layers which are surrounded by the first gate layer and of which depth, width and gap are smaller than those of the first gate layer.

With the above measure, when the static induction transistor moves from an on state to an off state, at first an electron flow from a source layer is prevented with a low gate voltage due to a pinch off effect, in other words overlapping of depletion layers of the second gate layers having a narrow width, thereafter, an increasing drain voltage is prevented up to a high voltage with a further high gate voltage due to a pinch off effect, in other words overlapping of depletion layers of the first gate layer having a wide width, thereby, an SIT with an excellent off characteristic is realized. Herein, when the gap between the second gate layers is extremely narrowed, an SIT having a normally off function can be realized which exerts a pinch off effect under a short circuited or an open circuited condition between a gate electrode and a source electrode.

Further, according to the present invention, when forming the second gate layers with a narrow width through an ion implantation, an extremely thin implantation mask can be applied depending on a decrease of the implantation energy and an implantation mask permitting a high processing accuracy is obtained, thereby, an SIT with a high off gain can be produced with a high yield.

### BRIEF DESCRIPTION OF THE DRAWINGS

Fig. 1 is a perspective cross sectional view showing a first embodiment of the SiC static induction transistor according to the present invention ;
Fig. 2 is a perspective cross sectional view showing a conventional static induction transistor ;
Fig. 3 is a perspective cross sectional view showing a second embodiment of the SiC static induction transistor according to the present invention ;
Fig. 4A is a plane view of a layout of base cells of the SiC static induction transistor one of which is shown in Fig. 3 ;
Fig. 4B is a cross sectional view taken along a line IVB-IVB in Fig. 4A ; and
Figs. 5A through 5E are views for explaining production process of the SiC static induction transistor as shown in Fig. 3.

### DETAILED DESCRIPTION OF THE EMBODIMENTS

Hereinbelow, the present invention is explained in detail with reference to the embodiments as shown in the drawings.

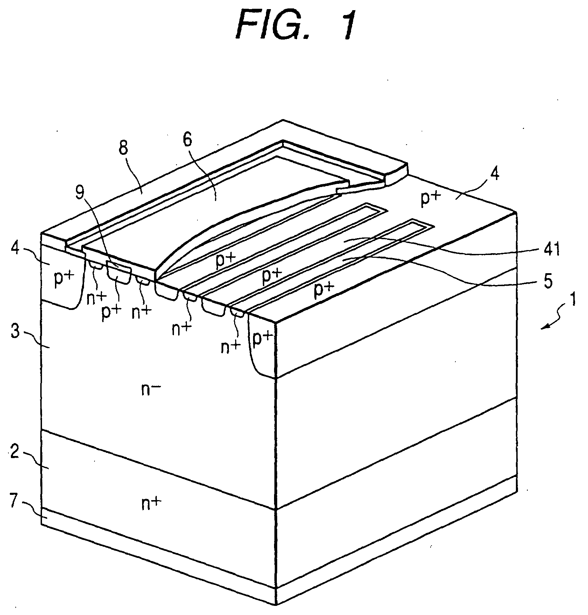

Fig. 1 is a perspective cross sectional view of a base unit cell of a static induction transistor representing the first embodiment according to the present invention. An SiC semiconductor base body 1 in a shape of parallel flat plate having upper and lower major faces is constituted by a low resistance n⁺ conductive type layer 2 having an impurity density of about 3×10¹⁹cm⁻³ and a thickness of about 300*µ*m, and a high resistance n⁻ conductive type layer 3 having an impurity density of about 1×10¹⁶cm⁻³ lower than that of the n⁺ conductive type layer 2 and a thickness of about 12*µ*m. On one of the major face thereof on which the n- conductive type layer 3 is exposed a p⁺ conductive type first gate layer 4, of which depth, width and boron implantation amount are respectively about 1*µ*m, about 1*µ*m and about 1×10¹⁵/cm² and having a higher impurity density than that of the n- conductive type layer 3, is provided along the circumference of the cell. Further, near the one major surface area having a width of about 2*µ* m surrounded by the first gate layer 4 a plurality of stripe shaped p⁺ conductive type second gate layers 41, of which depth, width and boron implantation amount are respectively about 0.15*µ*m, about 0.2*µ*m and about 1×10¹⁴/cm² and having a higher impurity density than that of the n- conductive type layer 3 are provided with a gap of about 0.2*µ*m, and the second gate layers 41 are contacted to the first gate layer 4 at the edge portion of the cell. The gap between adjacent second gate layers 41 is narrower than that between the first gate layers 4. Further, the depth of the second gate layers 41 from the major surface of the semiconductor base body 1 is shallower than that of the first gate layer 4. Between adjacent two second gate layers 41 the n- conductive type layer 3 having a width of about 0.2*µ*m is disposed. On the one major surface area surrounded by the second gate layers 41 and having a width of about 0.2*µ*m the n⁺ conductive type source layer 5 of which depth and nitrogen implantation amount are respectively about 0.05*µ*m and 1×10¹⁵/cm² and having a higher impurity density than that of the n- conductive type layer 3. Further, on the one major surface of the semiconductor base body 1 a source electrode 6 and a gate electrode 8, and on the other major surface thereof a drain electrode 7 are respectively provided. In order to prevent an electrical contact between the source electrode 6 and the respective gate layers 4 and 41 an insulating film 9 is interposed therebetween. A difference of the present embodiment from the conventional example as shown in Fig. 2 is the provision of the narrow width second gate layers 41.

Operations of the respective portions of the above will be explained. A turning off of a current between the source and drain is caused by applying a negative potential to the gate electrode 8 with respect to the source electrode 6. Since the gap between the second gate layers 41 is set at about 0.2*µ*m which is far narrower than that between the first gate layers 4 an overlapping of depletion layers is caused with a lower gate voltage of a few to a few tens volt so as to prevent an electron flow from the source layer 5. Due to prevention of the electron flow from the source layer 5 an internal impedance between the source and drain suddenly increases, and thereby, the drain voltage jumps up to a power source voltage. Although this high voltage can not keep prevented only by the shallow second gate layers 41, through application of a gate voltage corresponding to the voltage to be prevented, now an overlapping of depletion layers expanding from the first gate layers 4 having a deep junction and being disposed with a comparatively wide width is caused, and thereby the semiconductor element holds a high voltage off state due to a pinch off effect induced by the depletion layer overlapping. In this high voltage preventing operation, the quick suppression of the electron injection from the source layer 5 due to the pinch off effect of the second gate layers 41 makes easy the overlapping of the depletion layers from the first layers. As a result, even for a turning off from a high current density state a turning off operation with a high gain is enabled.

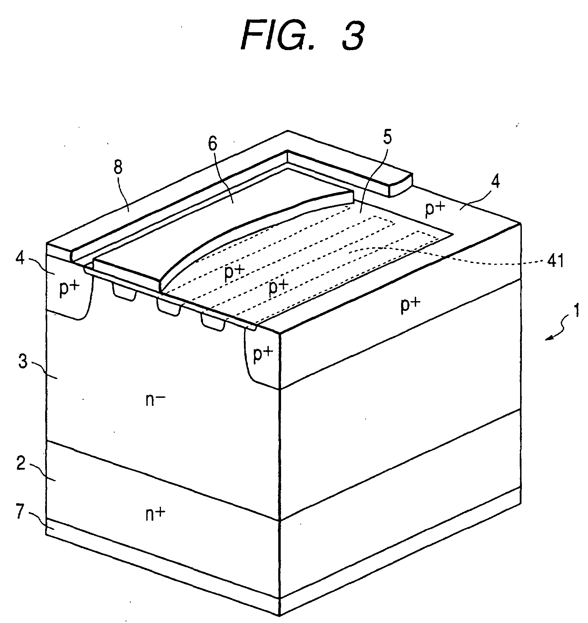

Fig. 3 is a perspective cross sectional view of a base unit cell of a static induction transistor representing the second embodiment according to the present invention. In the present embodiment, the portions bearing the same reference numerals as those in the first embodiment designate the same structures, conductivity type or the functions as those explained in connection with the first embodiment. A difference of the present embodiment from the embodiment as shown in Fig. 1 is that a source layer 5 overlaps the respective gate layers 4 and 41 and is contacted thereto. Since the source layer 5 overlaps and is contacted to the respective gate layers 4 and 41, and advantage that a required alignment accuracy can be reduced which significantly simplifies the production process.

An SIT of a high prevention voltage is required to have a gate source junction having a possibly high withstanding voltage, however, since the maximum electric field breakdown strength of a pn junction formed in SiC monocrystalline shows ten times higher than that formed in SiC, the SIT using an SiC monocrystalline as the base material makes use of such characteristic that even with a junction constituted by a high impurity density p and n layers a sufficiently high withstanding voltage can be obtained. Therefore, with the present embodiment a gate junction withstanding voltage of a few tens to a few hundreds volt is obtained.

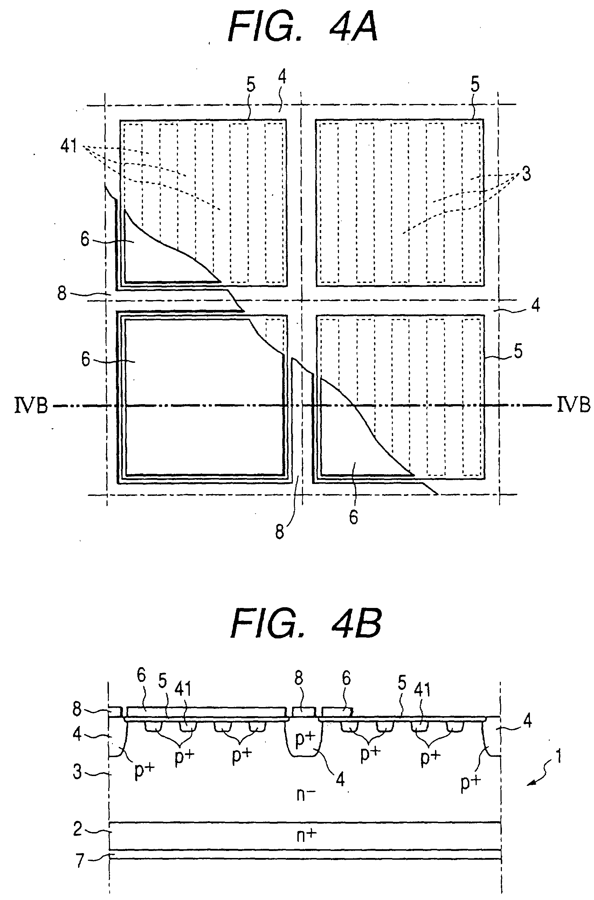

Fig. 4A shows a layout example of the unit cell as shown in the second embodiment according to the present invention, and Fig. 4B is a cross sectional view taken along the line IVB-IVB in Fig. 4A. The portions in Figs. 4A and 4B bearing the same reference numerals as those in the second embodiment as shown in Fig. 3 designate the same structures, conductivity type or the functions as those explained in connection with the second embodiment. The portion surrounded by a dashed line corresponds to a unit cell of the second embodiment as shown in Fig. 3, and in Fig. 4A a layout of total four unit cells is illustrated. Number of unit cells arranged together increases depending on a current capacity of the element concerned. In the present example the gate electrode 8 is provided on all of the surface of the first gate layers 4 on respective cells, however, the gate electrode 8 is not necessarily provided for all of the cells and can be provided partly to the extent that an electric resistance thereof permits. Further, when an insulating material is interposed between the source electrode 6 and the gate electrode 8, the source electrode 6 can be structured so as to cover most of the surface of the semiconductor chip.

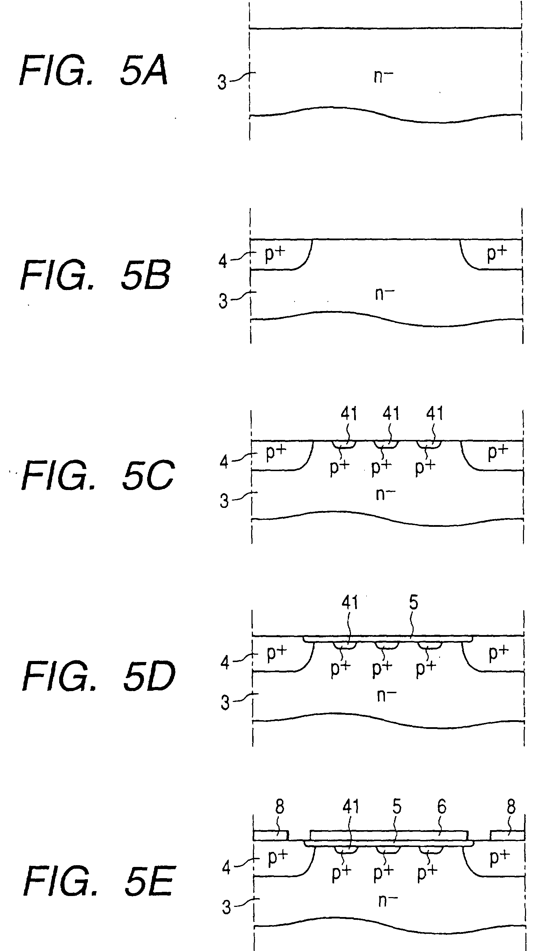

Figs. 5A through 5E are views showing major processes for producing the second embodiment according to the present invention. The portions in Figs. 5A through 5E bearing the same reference numerals as those in the second embodiment as shown in Fig. 3 designate the same structures, conductivity type or the functions as those explained in connection with the second embodiment. Fig. 5A shows a cross sectional view of the n- conductive type layer 3 at the one major surface of the semiconductor base body 1 and such as the n⁺ conductive type layer 2 at the lower portion thereof is omitted. In Fig. 5B, the p⁺ conductive type gate layer 4 is formed in the part of the n- conductive type layer 3 through selective boron ion implantation from the surface of the n- conductive type layer 3. The implantation amount was about 1×10¹⁵/cm², and the implantation energy was varied in three steps, in that at 500keV, 300keV and 50keV. At this instance, a photo resist film having a thickness of about 4.0*µ* m was used as the implantation mask. Subsequently, in Fig. 5C, boron ions was implanted with an implantation amount of about 1×10¹⁴/cm² and with an implantation energy of about 50keV, while using a photo resist film having a thickness of about 0.3*µ*m as the implantation mask. Thereafter, in Fig. 5D, nitrogen ions were implanted with an implantation amount of about 1×10¹⁴/cm² and with an implantation energy of about 30keV, while using a photo resist film having a thickness of about 0.3*µ*m as the implantation mask. After the ion implantation, the semiconductor base body 1 was subjected to an activation treatment by annealing the same at a temperature of about 1500°C. In Fig. 5E, metals of Ti/Al and Ni were respectively deposited on the surfaces of the first gate layers 4 and the source layer 5 to complete the function regions of the device.

In the above embodiments, a semiconductor base body 1 of n conductive type is exemplified, however, the present invention likely applicable to a semiconductor base body of p conductive type, in such case all of the conductive type as shown in the embodiments are reversed.

According to the present invention, an SiC static induction transistor with an excellent off characteristic can be realized while eliminating a processing difficulty.

## Claims

1. A static induction transistor comprising :
an SiC semiconductor base body (1) having first conductivity type ;
a first gate layer (4) of second conductivity type formed on one major surface of said SiC semiconductor base body (1) ;
a source layer (5) of first conductivity type formed on the one major surface of said SiC semiconductor base body (1) ;
a source electrode (6) being contacted to said source layer (5) ;
a gate electrode (8) being contacted to said first gate layer (4) ; and
a drain electrode (7) being contacted to another major surface of said SiC semiconductor base body (1),
characterized in that the static induction transistor further comprising, a plurality of second gate layers (41) of second conductivity type which are disposed adjacent to the first gate region in a region surrounded by said first gate layer (4) on the one major surface of said SiC semiconductor base body (1) and of which width and depth are selected smaller than those of the first gate region.

2. A static induction transistor according to claim 1, characterized in that said source layer (5) overlaps said first gate layer (4) and said second gate layers (41) and is contacted therewith.

3. A static induction transistor according to claim 1, characterized in that said second gate layers (41) are disposed so as to surround said source layer (5).

4. A static induction transistor according to claim 1, characterized in that a gap between the adjacent second gate layers (41) is set in such a manner that depletion layers expanding from the respective adjacent gate layers (41) overlap each other under a short circuited or an open circuited state between said gate electrode (8) and said source electrode (6).
